# EUROPEAN PATENT APPLICATION

(11) **EP 3 392 915 A1**
(43) Date of publication of application: **24.10.2018**
(21) Application number: 16875995.9
(22) Date of filing: 13.12.2016
(51) Int. Cl.: H01L 31/05, H01L 31/02, H01L 31/042, H01L 31/0224, H01L 31/0216, H01G 9/20

(54) **MONOLITHIC-TYPE MODULE OF PEROVSKITE SOLAR CELL, AND MANUFACTURING METHOD THEREFOR**

(30) Priority: 14.12.2015 KR 20150177997
(71) Applicant: Dongjin Semichem Co., Ltd, Incheon 22824 (KR)
(72) Inventor: JIN, Young Sam, Hwaseong-City Gyeonggi-do 18635 (KR)
(74) Representative: Grünecker Patent- und Rechtsanwälte PartG mbB
(86) International application number: PCT/KR2016/014573
(87) International publication number: WO 2017/105053

(57) **Abstract**

A monolithic-type module of a perovskite solar cell includes: a plurality of unit cells including a substrate, a first electrode layer formed on the substrate and having conductivity, a perovskite optical absorption layer formed on the upper surface of the first electrode layer, and made of a porous metal oxide to which an optical absorber having a perovskite structure is attached, and a hole transport layer formed on the upper surface of the perovskite optical absorption layer; and a second electrode layer formed on the hole transport layer and formed of a conductive material, wherein an interconnection partition electrode of a predetermined height is formed between individual unit cells such that the plurality of unit cells are connected in series by interconnection wiring for electrically connecting the second electrode layer of each unit cell with the first electrode layer of a neighboring unit cell by the interconnection partition electrode.

## Description

### [Technical Field]

The present invention relates to a perovskite solar cell, and particularly to a monolithic-type module of a perovskite solar cell including solid-type thin film solar cells using a perovskite optical absorber that enables an in-series connection structure of a monolithic structure, and a manufacturing method thereof.

### [Background Art]

A dye-sensitized solar cell is manufactured at a sharply lower cost than a conventional silicon-based solar cell and thus may replace a conventional amorphous silicon solar cell, and it is a photoelectrochemical solar cell using a main constituting material such dye molecules absorbing visible rays and producing an electron-hole pair and a transition metal oxide transporting a produced electron, unlike the silicon solar cell.

The dye-sensitized solar cell has a module structure of a W type, a Z type, a monolithic type, and the like.

A monolithic-type DSC module needs no counter electrode substrate which is used in the W type and the Z type, and thus is manufactured at a low cost, and is manufactured by sequentially disposing layers on an operating electrode substrate and has an effect of high productivity with a comparatively brief manufacturing process.

The monolithic-type DSC module has an integrated structure including a transparent conductive layer, a photo-electrode layer, a porous insulation layer, and a counter electrode layer having a catalyst electrode on a transparent substrate.

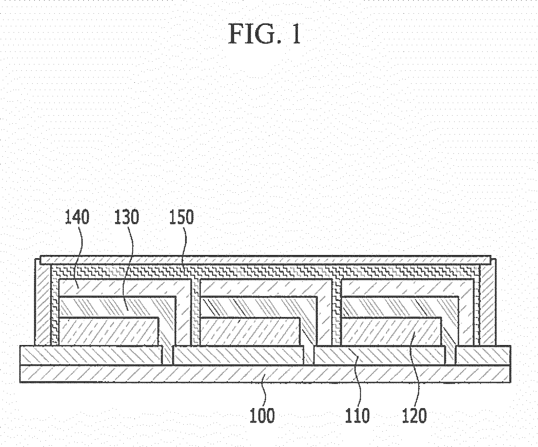

FIG. 1 is a cross-sectional view showing a structure of a general conventional monolithic-type solar cell module.

The conventional monolithic-type solar cell module includes a transparent substrate 100, a transparent electrode 110, a photo-electrode layer prepared by having a dye adsorbed onto a porous oxide semiconductor layer 120, a porous insulation layer 130, a catalyst layer 140, and a porous counter electrode layer 150.

The transparent substrate 100 is transparent so that external light may enter, and may be, for example, formed of a transparent glass or plastic. Specific examples of the plastic may include polyethylene terephthalate (PET), polyethylene naphthalate (PEN), polycarbonate (PC), polypropylene (PP), polyimide (PI), triacetyl cellulose (TAC), and the like.

A plurality of transparent electrodes (TCO) 110 are formed on the transparent substrate 100. Herein, the transparent electrode 110 may consist of a transparent material such as indium tin oxide (ITO), fluorine tin oxide (FTO), antimony tin oxide (ATO), zinc oxide, tin oxide, ZnOGa₂O₃, ZnO-Al₂O₃, and the like as a TCO glass.

The transparent electrode 110 may consist of a single layer or a multilayer of transparent materials.

On the transparent electrode 110, the photo-electrode layer is formed to be electrically connected thereto.

As for the photo-electrode layer, the porous oxide semiconductor layer 120 (a TiO₂ thin film layer) in which a crystal oxide onto which a dye is adsorbed is formed as a porous layer may be mainly used, and herein, ZnO, SnO₂, and the like besides TiO₂ may be variously used.

The photo-electrode layer is formed as the porous oxide semiconductor layer 120 onto which a dye is adsorbed, and the porous oxide semiconductor layer 120 includes a metal oxide particle.

The dye, which absorbs external light and produces electrons, is adsorbed on the surface of the porous oxide semiconductor layer 120.

The dye may be made of a metal composite including aluminum (Al), platinum (Pt), palladium (Pd), europium (Eu), lead (Pb), iridium (Ir), ruthenium (Ru), and the like.

The porous insulation layer 130 wraps the photo-electrode layer and thus blocks the photo-electrode layer from physically and electrically contacting a counter electrode.

The porous insulation layer 130 may be formed of an oxide semiconductor as a material having a high refractive index and high resistance, and for example, one selected from a zirconium oxide, a magnesium oxide, an aluminum oxide, a titanium oxide, or a mixture thereof may be used.

The catalyst layer 140 functions as a catalyst electrode bound to the surface of the porous counter electrode layer 150, and thus promotes a reaction of an electrolyte solution present in the porous insulation layer 130.

The catalyst layer 140 may be formed of a material for forming a catalyst, for example, a metal material such as platinum, palladium, and the like, or a carbon-based material such as carbon black, carbon nanotubes, and the like, may be used.

The porous counter electrode layer 150 may be formed of a conductive binder having high conductivity and an anti-corrosion property with respect to an electrolyte solution, and specifically, titanium, tungsten, nickel, and the like.

The monolithic-type DSC module is fabricated by coating a metal oxide paste on the transparent electrode 110 through a screen printing method to form the porous insulation layer 130 on the porous oxide semiconductor layer 120, and coating a conductive binder paste on the catalyst layer 140 through the screen printing method to form the porous counter electrode layer 150.

This monolithic-type DSC module process forms layers by screenprinting a paste and thus may easily form a fine pattern.

A dye-sensitized solar cell may be manufactured in two forms, that is, a liquid-type structure consisting of a titanium dioxide photo-electrode onto which a dye is adsorbed and including an oxidation/reduction electrolyte, and a solid-type structure using a solid hole conductor instead of the liquid electrolyte

The liquid electrolyte mainly uses an iodine material, but the solid conductor uses an organic molecule or polymer material.

The liquid-type structure may deteriorate efficiency and thus cause a problem in terms of stability of a device, because when a solar cell is not sealed tightly, the liquid electrolyte is evaporated or reacts with water or oxygen molecules that permeate from the air, but the solid-type structure has no electrolyte leakage problem and thus may be manufactured into a stable solar cell.

A dye that is mainly used in a liquid dye-sensitized solar cell is an organometal compound including a ruthenium metal, which requires a titanium dioxide thickness of greater than or equal to 10 µm in order to sufficiently adsorb light up to an extinction coefficient (a degree of light absorption) in a range of 10,000 to 50,000.

An organic dye including this ruthenium-based metal needs an adsorption time of 2 hours to 24 hours, during which it is adsorbed on the surface of an oxide and forms a solar cell and thus has a drawback of lengthening a manufacturing process time.

On the other hand, a perovskite optical absorber has an extinction coefficient that is greater than or equal to 10 times higher than that of the organic dye, and thus may sufficiently adsorb light at a relatively thin titanium dioxide thickness of 0.1 to 1 µm.

The organic dye shows efficiency of about 10 % due to a loss during a charge separation process, but when a perovskite light absorber (CH₃NH₃Pbl₃) is used on titanium dioxide of a nanoparticle, the perovskite light absorber accumulates photocharges and thus increases the efficiency to up to double or higher.

When the perovskite material is used for a liquid-type dye-sensitized solar cell, it is dissolved in a liquid electrolyte and thus deteriorates performance down to 80 % within a few hours.

Accordingly, primary efforts have concentrated on developing a solid-type thin film solar cell, and particularly, research on coating a perovskite material on a metal oxide has been spurred to accomplish high efficiency.

As shown in FIG. 1, the conventional DSC monolithic-type structure is not applied to this solid-type thin film solar cell using a perovskite light absorber due to process problems, and thus may not realize a film pattern, resultantly not allowing implementation of a device.

A conventional solid-type thin film solar cell using a perovskite light absorber does not have a monolithic-type structure like the conventional DSC, and thus has no in-series connection structure.

### [Prior Arts]

### [Patent References]

Korean Patent No. 10-1172374 (issue date: August 2, 2012), title of the invention: "Dye-sensitized solar cell using a perovskite-based dye and manufacturing method therefor"

### [DISCLOSURE]

### [Technical Problem]

In order to solve the problems, the present invention provides a monolithic-type module of a perovskite solar cell in which a solid-type thin film solar cell using a perovskite optical absorber is in-series connectable to have a monolithic structure, and a manufacturing method thereof.

### [Technical Solution]

A monolithic-type module of a perovskite solar cell according to features of the present invention in order to achieve the purpose includes:
a plurality of unit cells including a substrate, a first electrode layer formed on the substrate and having conductivity, a perovskite optical absorption layer formed on the upper surface of the first electrode layer, and made of a porous metal oxide to which an optical absorber having a perovskite structure is attached, and a hole transport layer formed on the upper surface of the perovskite optical absorption layer; and a second electrode layer formed on the hole transport layer and formed of a conductive material,
wherein an interconnection partition electrode of a predetermined height is formed between individual unit cells such that the plurality of unit cells are connected in series by interconnection wiring for electrically connecting the second electrode layer of each unit cell with the first electrode layer of a neighboring unit cell by the interconnection partition electrode.

A monolithic-type module of a perovskite solar cell according to features of the present invention includes:
a plurality of unit cells including a substrate, a first electrode layer formed on the substrate and having conductivity, a perovskite optical absorption layer formed on the upper surface of the first electrode layer, and made of a porous metal oxide to which an optical absorber having a perovskite structure is attached, and an electron transport layer formed on the upper surface of the perovskite optical absorption layer and made of an electron transport material to accept an electron from the perovskite optical absorption layer and to transport it; and a second electrode layer on the electron transport layer and formed of a conductive material,
wherein an interconnection partition electrode of a predetermined height is formed between individual unit cells such that the plurality of unit cells are connected in series by interconnection wiring for electrically connecting the second electrode layer of each unit cell with the first electrode layer of a neighboring unit cell by the interconnection partition electrode.

A method of manufacturing a perovskite solar cell according to features of the present invention includes:
performing patterning of a transparent conducting oxide (TCO) on a transparent substrate 200 to form a plurality of transparent electrodes spaced apart from each other by a certain distance;
forming an interconnection partition electrode of a predetermined height at one end of each transparent electrode;
after forming the interconnection partition electrode, forming a perovskite optical absorption layer made of a porous metal oxide to which an optical absorber having a perovskite structure is attached, on the upper surface of each transparent electrode;
forming a hole transport layer or an electron transport layer on the upper surface of the perovskite optical absorption layer; and
forming a metal electrode made of a conductive material on the hole transport layer or the electron transport layer to form a plurality of unit cells, wherein the metal electrode of each unit cell is electrically connected to the transparent electrode of a neighboring unit cell with interconnection wiring by the interconnection partition electrode.

According to the above method, the present invention may have an effect of realizing an in-series connection structure of a monolithic structure with a solid-type thin film solar cell using a perovskite light absorber.

The present invention has an effect of forming layers in a wet process such as spin coating or wet coating due to the interconnection partition electrode.

### [Advantageous Effects]

The present invention has an effect of maximizing a photovoltaic area, since each unit cell closely contacts without an empty space at both surfaces of the interconnection partition electrode with the interconnection partition electrode therebetween as a monolithic-type structure.

The present invention has an effect of manufacturing a solar cell without an insulation layer as a solid type.

The coating process of the interconnection partition electrode of the present invention may realize a fine pattern and thus has an effect of increasing an active area.

The present invention may form a hole transport layer of a solar cell with a P-type inorganic oxide, a monomolecular organic material, or a polymeric organic material to increase stability at a high temperature and obtain excellent crystallinity and thus increase hole transport characteristics and resultantly, efficiency of a solar cell.

The present invention may form the hole transport layer of a solar cell into a thin film with the inorganic oxide, the monomolecular organic material, or the polymeric organic material, and thus has an effect of maintaining transparency and easily realizing a transparent solar cell.

### [Description of the Drawings]

FIG. 1 is a cross-sectional view showing a structure of a general conventional monolithic-type solar cell module.
FIG. 2 is a layer cross-sectional view showing a structure of a monolithic-type module of a perovskite solar cell according to an exemplary embodiment of the present invention.
FIG. 3 is a view showing a method of manufacturing a monolithic-type perovskite solar cell according to an exemplary embodiment of the present invention.

### [Mode for Invention]

In the following detailed description, only certain example embodiments of the present invention have been shown and described, simply by way of illustration. As those skilled in the art would realize, the described embodiments may be modified in various different ways, all without departing from the spirit or scope of the present invention. Accordingly, the drawings and description are to be regarded as illustrative in nature and not restrictive. Like reference numerals designate like elements throughout the specification.

In addition, unless explicitly described to the contrary, the word "comprise" and variations such as "comprises" or "comprising" will be understood to imply the inclusion of stated elements but not the exclusion of any other elements.

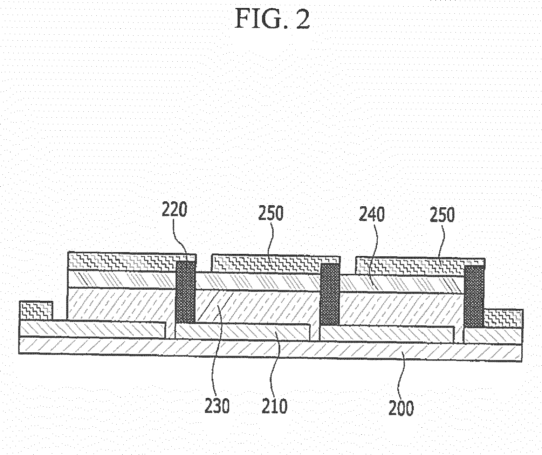

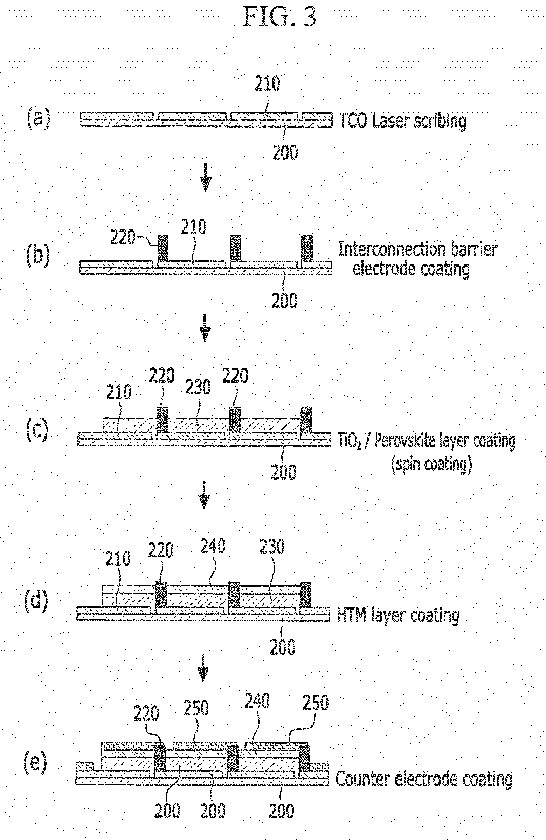

FIG. 2 is a layer cross-sectional view showing a structure of a monolithic-type module of a perovskite solar cell according to an exemplary embodiment of the present invention, and FIG. 3 is a view showing a method of manufacturing a monolithic-type perovskite solar cell according to an exemplary embodiment of the present invention.

In a method of manufacturing a monolithic-type perovskite solar cell according to an exemplary embodiment of the present invention, TCO patterning is performed on a transparent substrate 200 to form a plurality of transparent electrodes (TCO) 210 spaced apart from each other by a certain distance ((a) of FIG. 3).

The transparent substrate 200 is transparent so that external light may enter, and may be, for example, formed of a transparent glass or plastic. Specific examples of the plastic may be polyethylene terephthalate (PET), polyethylene naphthalate (PEN), polycarbonate (PC), polypropylene (PP), polyimide (PI), triacetyl cellulose (TAC), and the like.

The transparent electrode 210 may consist of a transparent material such as indium tin oxide (ITO), fluorine tin oxide (FTO), antimony tin oxide (ATO), zinc oxide, tin oxide, ZnOGa₂O₃, ZnOAl₂O₃, and the like as a TCO glass.

The transparent electrode 210 may consist of a single layer or a multilayer of transparent materials.

Each transparent electrode 210 is coated with an interconnection partition electrode 220 having a predetermined height along an edge of one terminal end in a dispensing coating method and a screen printing method ((b) of FIG. 3).

The interconnection partition electrode 220 may use any conductive material without a limit, and even an insulation material having a conductive layer. Specifically, at least one material selected from platinum, ruthenium, palladium, iridium, rhodium (Rh), osmium (Os), carbon (C), WO₃, TiO₂, Au, Cu, Ag, In, Ru, Pd, Rh, Ir, and a conductive polymer may be used.

A metal oxide paste of a nanoparticle is prepared by mixing titanium dioxide (TiO₂) powder with ethanol as a solvent to prepare a colloid solution in which the metal oxide is dispersed.

On the transparent electrode 210, the metal oxide paste is coated by using spin-coating technology and then sintered.

On a TCO glass coated with a TiO₂ film, a perovskite solution is coated by using spin-coating technology. In other words, on the upper surface of each transparent electrode 210, a perovskite light absorption layer 230 made of a porous metal oxide is formed ((c) of FIG. 3).

The method of manufacturing a perovskite-based dye is described in the above-mentioned prior art and will not be described in detail.

In this way, on each transparent electrode 210, the perovskite light absorption layer 230 including a porous oxide semiconductor layer and a perovskite-based dye adsorbed in the porous oxide semiconductor layer may be separated by the interconnection partition electrode 220 at every predetermined distance.

This interconnection partition electrode 220 may make a solar cell of the present invention into a device through formation of layers by using a wet process of spin coating or wet coating.

The porous oxide semiconductor layer is formed by coating a paste including a porous metal oxide on the transparent electrode 210, specific examples of which may be titanium, tin, zinc, tungsten, zirconium, gallium, indium, yttrium, niobium, tantalum, vanadium, a metal oxide such as ZnO and SnO₂, and the like, but are not limited thereto, and these may be used alone or as a mixture of two or more thereof.

Preferably, the porous oxide semiconductor layer may be a porous oxide semiconductor layer (TiO₂ thin film layer) that is present in a form of a porous film.

The perovskite optical absorber absorbs external light on the surface of the metal oxide particle to generate electrons, and may be represented by Chemical Formula 1 and may be prepared from MX₂ and CH₃NH₃X.

[Chemical Formula 1] CH3NH3MX3

Herein, M is Pb or Sn and X is a halogen.

A hole transport layer 240 used as a P-type conductive layer is formed on each perovskite optical absorption layer 230 ((d) of FIG. 3).

A metal electrode 250 is deposited on the hole transport layer 240 to form a plurality of unit cells ((e) of FIG. 3).

The metal electrode is formed using vapor deposition (chemical vapor deposition, CVD), sputter deposition, thermal evaporation, dip coating, E-beam evaporation, a PVD method (physical vapor deposition, PVD), atomic layer deposition (ALD), and the like.

One end of the deposited metal electrode 250 contacts the interconnection partition electrode 220 and is electrically connected thereto.

The height of the interconnection partition electrode 220 is greater than that of the hole transport layer 240.

The monolithic-type module of a perovskite solar cell according to the present invention has in-series connection by interconnection wiring for electrically connecting the metal electrode 250 of each unit cell with the transparent electrode 210 of a neighboring unit cell by the interconnection partition electrode 220.

The monolithic-type module of a perovskite solar cell according to the present invention may maximize a photovoltaic area, since each unit cell closely contacts without an empty space at both surfaces of the interconnection partition electrode 220 with the interconnection partition electrode 220 therebetween.

This monolithic-type perovskite solar cell is a solid type and needs no insulator layer.

The interconnection partition electrode 220 plays a role of separating and partitioning cells and thus may realize an in-series connection structure of solar cells.

On the perovskite optical absorption layer 230, a hole transport layer 240 is formed, and a metal electrode 250 is formed thereon.

The hole transport material may include a monomolecular hole transport material or a polymeric hole transport material, but is not limited thereto. For example, as the monomolecular hole transport material, spiro-MeOTAD [2,2',7,7'-tetrakis(N,N-p-dimethoxy-pheny)amino)-9,9'-spirobifluorene] may be used, and as the polymeric hole transport material, P3HT [poly(3-hexylthiophene)] may be used, but they are not limited thereto. In addition, for example, the hole transport layer 240 uses a dopant selected from a Li-based dopant, a Co-based dopant, and a combination thereof as a doping material, but the present invention is not limited thereto. For example, the hole transport material may include a mixture of spiro-MeOTAD, tBP, and Li-TFSI, but is not limited thereto.

However, the present invention is not limited thereto, and may include a solid electrolyte in the solar cell structure of FIGS. 2 and 3.

In addition, the present invention includes the hole transport layer 240, but it is not limited thereto, and may include an electron transport layer made of an electron transport material to accept an electron from the perovskite optical absorption layer 230 and transport it into the metal electrode 250.

The electron transport material may be [6,6]-phenyl-C61-butyric acid methyl ester (PCBM) of fullerene derivatives.

The electron transport layer may (ETL) include PCBM as an example, but it is not limited thereto, and may include any material capable of transporting electrons.

For example, ETL may include a polymer such as PBD, TAZ, or spiro-PBD, and a low molecular material such as Alq3, BAlq, or SAlq.

Electrons generated in the perovskite optical absorber are transported into a LUMO (Lowest Unoccupied Molecular Orbital) level of the electron transport material such as PCBM and transported into the metal electrode 250.

The metal electrode 250 may use any conductive material without limitation, and may specifically use at least one material selected from platinum, ruthenium, palladium, iridium, rhodium (Rh), osmium (Os), carbon (C), WO₃, TiO₂, Au, Cu, Ag, In, Ru, Pd, Rh, Ir, and a conductive polymer.

The conventional DSC monolithic-type structure may not be manufactured into a device due to formation of layers by using a wet process of spin coating, wet coating, or the like.

However, a perovskite solar cell of the present invention may be manufactured into a device due to formation of layers by introducing a partition electrode by using a wet process of spin coating, wet coating, or the like.

In other words, each unit cell of the perovskite solar cell may form the perovskite light absorption layer 230 as layers by using a wet process of spin coating or wet coating due to the interconnection partition electrode 220.

The perovskite solar cell of the present invention forms a porous oxide semiconductor layer and a perovskite light absorber after depositing and coating the interconnection partition electrode 220 before forming the perovskite light absorption layer 230.

The perovskite solar cell of the present invention may realize a fine pattern through a coating process of the interconnection partition electrode 220 and thus has an effect of increasing an active area.

The embodiments of the present invention are not implemented only by the apparatus and/or method described above, but may be implemented through a program for realizing the function corresponding to the configuration of the embodiment of the present invention, through a recording medium on which the program is recorded, and the present invention can be easily implemented by those skilled in the art from the description of the embodiments described above.

While this invention has been described in connection with what is presently considered to be practical example embodiments, it is to be understood that the invention is not limited to the disclosed embodiments, but, on the contrary, is intended to cover various modifications and equivalent arrangements included within the spirit and scope of the appended claims.

### [Description of Symbols]

200: transparent substrate
210: transparent electrode
220: interconnection partition electrode
230: perovskite optical absorption layer
240: hole transport layer or electron transport layer
250: metal electrode

According to the above structure, the present invention has an effect of an in-series connection structure of a monolithic structure with a solid-type thin film solar cell using a perovskite light absorber.

The present invention has an effect of forming layers by using a wet process of spin coating or wet coating due to the interconnection partition electrode.

The present invention may have an effect of maximizing a photovoltaic area, since each unit cell contacts without an empty space at both surfaces of the interconnection partition electrode with the interconnection partition electrode therebetween as a monolithic-type structure.

The present invention has an effect of manufacturing a solar cell without an insulation layer, as a solid type.

The present invention may realize a fine pattern through a coating process of the interconnection partition electrode and thus has an effect of increasing an active area.

The present invention forms a hole transport layer of a solar cell with a P-type inorganic oxide, a monomolecular organic material, or a polymeric organic material to increase stability at a high temperature and obtain excellent crystallinity, and thus may increase hole transport characteristics, and resultantly, efficiency of a solar cell.

The present invention forms the hole transport layer of a solar cell into a thin layer with the inorganic oxide, the monomolecular organic material, or the polymeric organic material and thus has an effect of maintaining transparency and easily realizing a transparent solar cell.

## Claims

1. A monolithic-type module of a perovskite solar cell, comprising:
a plurality of unit cells including a substrate, a first electrode layer formed on the substrate and having conductivity, a perovskite optical absorption layer formed on the upper surface of the first electrode layer, and made of a porous metal oxide to which an optical absorber having a perovskite structure is attached, and a hole transport layer formed on the upper surface of the perovskite optical absorption layer; and a second electrode layer formed on the hole transport layer and formed of a conductive material,
wherein an interconnection partition electrode of a predetermined height is formed between individual unit cells such that the plurality of unit cells are connected in series by interconnection wiring for electrically connecting the second electrode layer of each unit cell with the first electrode layer of a neighboring unit cell by the interconnection partition electrode.

2. A monolithic-type module of a perovskite solar cell, comprising:
a plurality of unit cells including a substrate, a first electrode layer formed on the substrate and having conductivity, a perovskite optical absorption layer formed on the upper surface of the first electrode layer, and made of a porous metal oxide to which an optical absorber having a perovskite structure is attached, and an electron transport layer formed on the upper surface of the perovskite optical absorption layer and made of an electron transport material to accept an electron from the perovskite optical absorption layer and to transport it; and a second electrode layer on the electron transport layer and formed of a conductive material,
wherein an interconnection partition electrode of a predetermined height is formed between individual unit cells such that the plurality of unit cells are connected in series by interconnection wiring for electrically connecting the second electrode layer of each unit cell with the first electrode layer of a neighboring unit cell by the interconnection partition electrode.

3. The monolithic-type module of a perovskite solar cell of claim 1, wherein the interconnection partition electrode has a height which is higher than the hole transport layer but lower than the upper surface of the second electrode layer.

4. The monolithic-type module of a perovskite solar cell of claim 2, wherein the interconnection partition electrode has a height which is higher than the electron transport layer and lower than the upper surface of the second electrode layer.

5. The monolithic-type module of a perovskite solar cell of claim 1 or claim 2, wherein each unit cell closely contacts both surfaces of the interconnection partition electrode with the interconnection partition electrode therebetween.

6. The monolithic-type module of a perovskite solar cell of claim 1 or claim 2, wherein
the interconnection partition electrode comprises at least one material selected from platinum, ruthenium, palladium, iridium, rhodium (Rh), osmium (Os), carbon (C), WO₃, TiO₂, Au, Cu, Ag, In, Ru, Pd, Rh, Ir, and a conductive polymer.

7. The monolithic-type module of a perovskite solar cell of claim 1 or claim 2, wherein
the hole transport layer is a hole transport material made of an inorganic oxide, a monomolecular organic material, or a polymeric organic material, the electron transport layer is an electron transport material made of a monomolecular organic material or a polymeric organic material, and the second electrode layer comprises at least one material selected from platinum, ruthenium, palladium, iridium, rhodium (Rh), osmium (Os), carbon (C), WO₃, TiO₂, Au, Cu, Ag, In, Ru, Pd, Rh, Ir, and a conductive polymer as a conductive material.

8. The monolithic-type module of a perovskite solar cell of claim 1 or claim 2, wherein in each unit cell, the perovskite optical absorption layer is formed as a layer by using a wet process of spin coating or wet coating due to the interconnection partition electrode.

9. A method of manufacturing a perovskite solar cell, comprising:
performing patterning of a transparent conducing oxide (TCO) on a transparent substrate 200 to form a plurality of transparent electrodes spaced apart from each other by a certain distance;
forming an interconnection partition electrode of a predetermined height at one end of each transparent electrode;
after forming the interconnection partition electrode, forming a perovskite optical absorption layer made of a porous metal oxide to which an optical absorber having a perovskite structure is attached, on the upper surface of each transparent electrode;
forming a hole transport layer or an electron transport layer on the upper surface of the perovskite optical absorption layer; and
forming a metal electrode made of a conductive material on the hole transport layer or the electron transport layer to form a plurality of unit cells, wherein the metal electrode of each unit cell is electrically connected to the transparent electrode of a neighboring unit cell with interconnection wiring by the interconnection partition electrode.
